# EUROPÄISCHE PATENTSCHRIFT

(11) **EP 2 481 072 B1**
(45) Veröffentlichungstag und Bekanntmachung des Hinweises auf die Patenterteilung: **16.04.2014**
(21) Anmeldenummer: 10771675.5
(22) Anmeldetag: 31.08.2010
(51) Int. Cl.: H01J 37/05

(54) **BILDGEBENDER ENERGIEFILTER FÜR ELEKTRISCH GELADENE TEILCHEN SOWIE SPEKTROSKOP MIT EINEM SOLCHEN**
IMAGING ENERGY FILTER FOR ELECTRICALLY CHARGED PARTICLES AND SPECTROSCOPE HAVING THE SAME
FILTRE D'ÉNERGIE POUR IMAGERIE, POUR PARTICULES CHARGÉES ÉLECTRIQUEMENT, AINSI QUE SPECTROSCOPE ÉQUIPÉ D'UN TEL FILTRE

(30) Priorität: 24.09.2009 DE 102009044989
(43) Veröffentlichungstag der Anmeldung: 01.08.2012
(73) Patentinhaber: Funnemann, Dietmar, 13187 Berlin (DE)
(72) Erfinder: Funnemann, Dietmar, 13187 Berlin (DE)
(74) Vertreter: WSL Patentanwälte Partnerschaft mbB
(86) Internationale Anmeldenummer: PCT/EP2010/062724
(87) Internationale Veröffentlichungsnummer: WO 2011/036038

(56) Entgegenhaltungen:
- DE-A1- 10 252 129
- RU-C1- 2 364 004
- US-A- 6 104 029
- ESCHER M ET AL: "NanoESCA: a novel energy filter for imaging x-ray photoemission spectroscopy; NanoESCA: a novel energy filter for imaging XPS", JOURNAL OF PHYSICS: CONDENSED MATTER, INSTITUTE OF PHYSICS PUBLISHING, BRISTOL, GB, Bd. 17, Nr. 16, 27. April 2005 (2005-04-27), Seiten S1329-S1338, XP020088941, ISSN: 0953-8984, DOI: DOI:10.1088/0953-8984/17/16/004

## Beschreibung

Die vorliegende Erfindung betrifft einen bildgebenden Energiefilter für elektrisch geladene Teilchen sowie ein Spektroskop mit einem solchen Energiefilter.

Energiefilter werden verwendet, um die Energie von geladenen Teilchen, wie z. B. Elektronen, zu bestimmen.

Um Materialien zu analysieren, werden in der Elektronenspektroskopie die Elektronen des zu untersuchenden Materials angeregt. Dies kann beispielsweise mit Hilfe von eingestrahlten Elektronen aber auch durch Röntgenstrahlung oder UV-Strahlung erfolgen.

Die kinetische Energie der Elektronen wird anschließend gemessen. Dazu kommt ein Elektronenspektrometer zum Einsatz, mit dessen Hilfe die Anzahl der angeregten Elektronen mit einer bestimmten kinetischen Energie ermittelt werden kann.

Bildgebende Energiefilter für elektrisch geladene Teilchen sind beispielsweise aus der EP 1 559 126 bekannt.

Dieser Energiefilter baut auf einem Halbkugelanalysator auf. Ein Halbkugelanalysator besteht aus zwei metallischen Halbkugeln. Eine ist konkav geformt, während die andere konvex ausgebildet ist. Die Krümmungsmittelpunkte der beiden Halbkugeln fallen aufeinander. An die Halbkugeln werden unterschiedliche Spannungen angelegt, so dass sich zwischen den beiden Halbkugeln ein elektrisches Feld ausbildet. Elektronen, die energiegefiltert werden sollen, können nun über eine Eintrittsfläche in die Lücke zwischen die beiden Halbkugeln eingeschossen werden. Elektronen mit einer kinetischen Energie, die in einem schmalen Energiebereich liegt (auch Passenergie genannt) können den Analysator vollständig durchlaufen und einen hinter einer Austrittsfläche angeordneten Detektor erreichen. Elektronen mit zu hoher Energie werden auf die äußere Halbkugel treffen, während Elektronen mit zu geringer Energie auf die innere Halbkugel treffen werden.

Der Halbkugelanalysator ist fokussierend, d.h. Elektronen mit gleicher Energie werden in erster Näherung unabhängig von ihrem exakten Eintrittswinkel in den Halbkugelanalysator an der Austrittsblende nahezu auf denselben Punkt fokussiert. Am Ausgang des Halbkugelanalysators lassen sich daher Elektronen einer bestimmten Energie detektieren. Durch Verändern des elektrischen Feldes zwischen der inneren und der äußeren Halbkugel kann die Passenergie eingestellt werden.

Der Halbkugelanalysator arbeitet als Energiefilter, d. h. die Energie der geladenen Teilchen kann bestimmt werden. Die angeregten Elektronen treffen im allgemeinen unter unterschiedlichen Winkeln und/oder an unterschiedlichen Orten auf die Eintrittsfläche des Halbkugelanalysators auf.

Die Orts- und Winkelverteilungen lassen prinzipiell Rückschlüsse auf den Ursprung der geladenen Teilchen zu.

Wird beispielsweise eine Probe mit einer geeigneten Strahlungsquelle, wie z. B. einer Elektronenquelle bestrahlt, so können Elektronen aus der Probenoberfläche herausgelöst werden oder die Elektronen der Elektronenquelle an der Oberfläche gebeugt werden.

Wird die Probenoberfläche auf die Eintrittsfläche des Halbkugelanalysator abgebildet, so enthält die örtliche Verteilung der Elektronen eine Information über den Aufbau der Probe an der Oberfläche. Die Winkelverteilung lässt Rückschlüsse über die geometrische Anordnung der Atome zu.

Die Orts- und Winkelverteilung geht jedoch durch die fokussierenden Eigenschaft des Halbkugelanalysators verloren, wenn die Austrittsfläche direkt auf den Detektor abgebildet wird.

In der EP 1 559 126 ist daher bereits vorgeschlagen worden, zwei hintereinander geschaltete Halbkugelanalysatoren zu verwenden. Dabei dient der erste Halbkugelanalysator dazu, nur geladene Teilchen mit einer Passenergie weiterzuleiten, während der zweite Halbkugelanalysator die Orts- und Winkelverteilung der geladenen Teilchen wiederherstellt.

Um die geladenen Teilchen, die aus dem ersten Halbkugelanalysator austreten, auf den Eingang des nachgeschalteten Halbkugelanalysators abzubilden, werden Transferlinsen, d. h. Linsen für geladene Teilchen, verwendet. Durch diese Maßnahme entsteht ein bildgebender Energiefilter, da der zweite Halbkugelanalysator die Bildfehler des ersten korrigiert.

Es ist jedoch bekannt, dass in optisch abbildenden Systemen für geladene Teilchen bei Verwendung statischer, raumladungsfreier und rotationssymmetrischer Rohrlinsen die chromatische Aberration (Farbfehler) und die sphärische Aberration (Öffnungsfehler) grundsätzlich nicht verschwinden. Diese der Transferlinsen immanente Fehler begrenzen die Leistungsfähigkeit des Systems und führen dazu, dass das bekannte System nur einen geringen Akzeptanzwinkel aufweist, da die Abbildungsqualität von mit größerem Einfallswinkel auf die Eintrittsfläche auftreffenden Elektronen zu schlecht ist.

Ausgehend von dem beschriebenen Stand der Technik ist es daher Aufgabe der vorliegenden Erfindung, einen bildgebenden Energiefilter bzw. ein Spektroskop mit solch einem bildgebenden Energiefilter zur Verfügung zu stellen, das eine höhere Orts- und Winkelauflösung aufweist und das mit einem größeren Akzeptanzwinkel betrieben werden kann.

Erfindungsgemäß wird diese Aufgabe durch einen bildgebenden Energiefilter für elektrisch geladene Teilchen mit einem toroidalen Energieanalysator, vorzugsweise mit einem Halbkugelanalysator, mit einer Eintrittsebene und einer Austrittsebene gelöst, bei dem ein Spiegelelement für elektrisch geladene Teilchen vorgesehen und derart angeordnet ist, dass geladene Teilchen, die den toroidalen Energieanalysator über die Austrittsebene verlassen, durch das Spiegelelement zurück in den toroidalen Energieanalysator reflektiert werden, so dass die geladenen Teilchen den toroidalen Energieanalysator ein weiteres Mal in umgekehrter Laufrichtung durchlaufen.

In umgekehrter Laufrichtung bedeutet nicht, dass die geladenen Teilchen exakt den gleichen Weg nehmen, sondern den Energieanalysator von der Austrittsfläche zur Eintrittsfläche durchqueren. In einer bevorzugten Ausführungsform treffen die geladenen Teilchen unter einem ersten Winkel auf die Eintrittsfläche und verlassen diese nachdem sie den Energieanalysator zweimal durchquert haben unter einem zweiten Winkel, wobei der erste und der zweite Winkel entgegengesetzt gleich sind, d.h. der einfallende Strahl, das Einfallslot und der austretende Strahl liegen in einer Ebene und Einfallswinkel und Austrittswinkel sind gleich.

Wie bereits in der EP 1 559 126 beschrieben, ist es nicht unbedingt notwendig, einen Halbkugelanalysator zu verwenden. Prinzipiell ist jeder toroidale Energieanalysator geeignet, wie z. B. auch ein Zylinderanalysator oder eine Kugelsektoranalysator. Entsprechende Beispiele sind in der EP 1 559 126 beschrieben.

Auch wenn im folgenden die vorliegende Erfindung am Beispiel des besonders bevorzugten Halbkugelanalysators beschrieben wird, versteht es sich, dass stattdessen auch jeder andere toroidale Energieanalysator verwendet werden könnte.

Die erfindungsgemäße Anordnung eines entsprechenden Reflexionsspiegels für geladene Teilchen sorgt zunächst dafür, dass auf dem zweiten toroidalen Energieanalysator verzichtet werden kann. Stattdessen werden die geladenen Teilchen durch den Spiegel zurück in den ersten toroidalen Energieanalysator reflektiert.

Prinzipiell ist es möglich, den Reflexionsspiegel direkt in der Austrittsebene des toroidalen Analysators zu positionieren. Reflexionsspiegel für geladene Teilchen weisen jedoch in der Regel eine feste, nicht zu vernachlässigende negative sphärische und chromatische Aberration auf.

Daher ist in einer bevorzugten Ausführungsform vorgesehen, dass zwischen Austrittsebene und Spiegelelement eine Transferlinseneinrichtung angeordnet ist. Transferlinseneinrichtung und Spiegelelement können dann derart eingerichtet werden, dass die Aberrationen der Transferlinseneinrichtung durch das Spiegelelement reduziert werden.

Dabei ist die Transferlinseneinrichtung derart ausgelegt, dass sie das Zwischenbild ZB₁ in der Austrittsebene des Energieanalysators mit einer Linearvergrößerung V_{L} = ZB₂/ZB₁< 0 auf das Spiegelelement als Zwischenbild der Größe ZB₂ abbildet.

Die Transferlinseneinrichtung kann prinzipiell genauso ausgebildet sein wie in der EP 1559126 beschrieben ist.

In einer besonders bevorzugten Ausführungsform ist die Linearvergrößerung V_{L} = -1. Weiterhin ist es zweckmäßig, wenn die Winkelvergrößerung V_{W} negativ ist und am besten V_{W}= -1 ist.

Die Transferlinseneinrichtung weist in einer bevorzugten Ausführungsform mindestens zwei Linsen für elektrisch geladene Teilchen auf.

Das Spiegelelement kann ein elektrostatischer Spiegel sein. Grundsätzlich ist jedoch jedes Spiegelelement geeignet, durch welches die geladenen Teilchen reflektiert werden können. Durch die erfindungsgemäße Anordnung des Spiegelelements können die chromatische Aberration und/oder die sphärische Aberration der Transferlinseneinrichtung reduziert werden, und daher die Qualitätsanforderungen an die Transferlinseneinrichtung reduziert werden, ohne dass die Auflösung nennenswert verschlechtert werden. Es ist grundsätzlich einfacher und damit auch erheblich kostengünstiger, die Abbildungsfehler der Transferlinseneinrichtung durch die Anpassung des Spiegelelementes zu korrigieren als mit hohem Aufwand die Transferlinseneinrichtung zu verbessern, zumal der Abbildungsfehler der Transferlinseneinrichtung aufgrund theoretischen Überlegungen nicht völlig reduziert werden kann.

Die Kombination aus Spiegelelement und Transferlinseneinrichtung ist daher in der Lage, die grundsätzlich vorhandenen Abbildungsfehler bei der Verwendung einer Transferlinseneinrichtung zu reduzieren und im Idealfall sogar zu kompensieren.

Darüber hinaus können durch die Kombination aus Transferlinseneinrichtung Spiegelelement, deren optische Eigenschaften leicht beeinflusst und daher angepasst werden können, zusätzlich eventuell vorhandene weitere Bildfehler, die in Abbildungs- oder Übertragungssystemen außerhalb des Energieanalysators begründet sind, reduziert werden. Werden beispielsweise die geladenen Teilchen mit einer Linse auf der Eintrittsfläche des Energieanalysators abgebildet, so wird diese Linse einen Abbildungsfehler verursachen, welcher ebenfalls in einem Kalibriervorgang mit Hilfe der Transferlinseneinrichtung und/oder dem Spiegelelement reduziert oder sogar vollständig kompensiert werden kann.

Da erfindungsgemäß die geladenen Teilchen über die Eintrittsebene des toroidalen Energieanalysators eintreten als auch nach der Reflexion wieder austreten, ist in einer bevorzugten Ausführungsform ein Trennelement für geladene Teilchen vorgesehen. Mit Hilfe dieses Trennelementes können die eintreffenden Teilchen von den austretenden Teilchen getrennt werden.

In einer besonders bevorzugten Ausführungsform wird das Trennelement durch einen Magnetumlenker mit einer Eintrittsfläche für geladene Teilchen, einer Energiefilterfläche und einer Austrittsfläche für energiegefilterte geladene Teilchen verwirklicht. Der Magnetumlenker ist derart angeordnet, dass geladene Teilchen die unter einem Eintrittswinkel α, der vorzugsweise kleiner als 20° ist, auf die Eintrittsfläche des Magnetumlenkers treffen, durch den Magnetumlenker umgelenkt werden, so dass sie unter einem Austrittswinkel β, der vorzugsweise kleiner als 20° ist, aus der Energiefilterfläche des Magnetumlenkers austreten, und unter einem Eintrittswinkel γ, der vorzugsweise kleiner als 20° ist, auf die Eintrittsfläche des toroidalen Energieanalysators treffen und dass geladene Teilchen, die unter einem Austrittswinkel δ aus der Eintrittsfläche des toroidalen Analysators austreten, unter einem Eintrittswinkel ε, der vorzugsweise kleiner als 20° ist, auf die Energiefilterfläche des Magnetumlenkers treffen, von dem Magnetumlenker umgelenkt werden, so dass sie unter einem Austrittswinkel ζ, der vorzugsweise kleiner als 20° ist, die Austrittsfläche des Magnetumlenkers verlassen, wobei vorzugsweise zwischen Magnetumlenker und toroidalem Analysator eine oder mehrere Linsen vorgesehen sind.

Mit anderen Worten wird der Magnetumlenker dafür verwendet, den in den Energieanalysator eintretenden Strahl von dem aus dem Energieanalysator austretenden Strahl zu trennen. Magnetumlenker sind im Stand der Technik bekannt.

Der Begriff Energiefilterfläche wurde gewählt, um die Fläche des Magnetumlenkers zu bezeichnen, die dem Energiefilter zugewandt ist, d. h. die Fläche aus der die ungefilterten geladenen Teilchen austreten und nach der Energiefilterung wieder eintreten.

Die Fläche selbst muss daher keine energiefilternden Eigenschaften haben, auch wenn dies in speziellen Ausführungsformen so sein kann. Da in einem Magnetumlenker der Krümmungsradius der geladenen Teilchen von der Geschwindigkeit und somit von der Energie abhängt, wäre es möglich durch Anordnung von Blenden auf der Energiefilterfläche, diese selbst mit energiefilternder Eigenschaft auszustatten.

Der erfindungsgemäße bildgebende Energieanalysator kann prinzipiell in jedem beliebigen Spektroskop für geladene Teilchen verwendet werden. Vorzugsweise wird der Energieanalysator in einem Elektronenspektroskop verwendet, bei dem die zu untersuchenden geladenen Teilchen Elektronen sind.

In einer bevorzugten Ausführungsform weist das Spektroskop einen Detektor zur Erfassung der über die Eintrittsfläche des toroidalen Analysators austretenden geladenen Teilchen auf, wobei der Detektor vorzugsweise ein CCD-Detektor ist. Mit Hilfe des CCD-Detektors kann die Ortsinformation, die die energiegefilterten Elektronen besitzen, erfasst werden. Dabei ist der Detektor vorzugsweise derart angeordnet, dass er die über die Austrittsfläche des Magnetumlenkers austretenden geladenen Teilchen erfasst. In einer besondere Ausführungsform kann mindestens eine Vielkanalplatte, die vor einem Leuchtschirm angeordnet ist, verwendet werden, so dass der CCD-Detektor Teil einer Kamera ist und mit Hilfe einer Lichtoptik die auf dem Leuchtschirm entstehende Intensitätsverteilung auf den CCD-Detektor abbildet.

Weiter weist mit Vorteil das Spektroskop eine Probenaufnahme auf, die derart angeordnet ist, dass von einer auf der Probenaufnahme angeordneten Probe emittierte geladene Teilchen, gegebenenfalls nach Durchlaufen einer Abbildungsoptik unter einem Eintrittswinkel γ, der vorzugsweise kleiner als 20° ist, auf die Eintrittsfläche des toroidalen Energieanalysators treffen oder, falls ein Energiefilter mit Magnetumlenker verwendet wird, unter einem Eintrittswinkel α, der vorzugsweise kleiner als 20° ist, auf die Eintrittsfläche des Magnetumlenkers treffen.

Weiterhin kann eine Strahlungsquelle, vorzugsweise eine Elektronenquelle, eine Röntgenquelle oder eine Ultraviolett-Lichtquelle, zur Beaufschlagung einer auf der Probenaufnahme aufgenommenen Probe mit Strahlung vorgesehen sein. Dabei kann der Magnetumlenker eine Strahlungseintrittsfläche haben und die Strahlungsquelle derart angeordnet sein, dass Strahlung unter einem Eintrittswinkel β, der vorzugsweise kleiner als 10° ist, auf die Strahlungseintrittsfläche trifft und von dem Magnetumlenker derart umgelenkt wird, dass sie unter einem Austrittswinkel θ, der vorzugsweise kleiner als 10° ist, aus der Eintrittsfläche des Magnetumlenkers austritt und auf die Probenaufnahme gerichtet ist. Mit anderen Worten übernimmt der Magnetumlenker eine Doppelfunktion. Zum einen sorgt er dafür, dass die in den Energieanalysator eintretenden geladenen Teilchen von denen aus dem Energieanalysator austretenden Teilchen getrennt werden. Zum anderen kann der Magnetumlenker dazu verwendet werden, die von der Elektronenkanonen stammenden Elektronen (Primärelektronen) von denen aus der Probe stammenden angeregten Elektronen zu trennen.

In einer weiteren bevorzugten Ausführungsform ist die dispersive Ebene des toroidalen Analysators im wesentlichen senkrecht zu einer zwischen Probenaufnahme und Detektor verlaufenden gedachten Linie angeordnet. Dies hat den Vorteil, dass die Transferlinseneinrichtung und das Spiegelelement räumlich deutlich von der Detektoreinrichtung getrennt sind, so dass bei der Anordnung und Dimensionierung der einzelnen Elemente eine größere Freiheit besteht.

In einer bevorzugten Ausführungsform ist das Spektroskop ein abbildendes ESCA-Elektronenspektroskop ("Electron Spectroscopy for Chemical Analysis"). Alternativ könnte der erfindungsgemäße Energiefilter jedoch auch einem abbildenden Auger-Elektronen-Spektroskop, ein LEEM ("Low Energy Electron Microscope) oder ein Sekundärionen-Mikroskop sein.

In einer weiteren bevorzugten Ausführungsform wird die Winkelverteilung der in der Probe entstehenden geladenen Teilchen, in der Regel Elektronen, energiegefiltert auf den Detektor abgebildet. Hier kann das Spektroskop als LEED ("Low Energy Electron Diffraction") oder als XPD ("X-ray photoelectron diffraction") ausgebildet sein.

Des weiteren ist es möglich, den erfindungsgemäßen Energiefilter in zeitaufgelösten Messungen zu verwenden.

Weitere Vorteile, Merkmale und Anwendungsmöglichkeiten werden deutlich anhand der folgenden Beschreibung einer bevorzugten Ausführungsform und der zugehörigen Figuren. Es zeigen:
Figur 1 eine schematische Darstellung einer Transferlinseneinrichtung.
Figur 2 eine schematische Darstellung einer Kombination aus Transferlinseneinrichtung und Spiegelelement,
Figur 3 eine schematische Darstellung eines Halbkugelanalysators mit Spiegelelement und
Figur 4 eine schematische Darstellung eines erfindungsgemäßen Spektroskops.

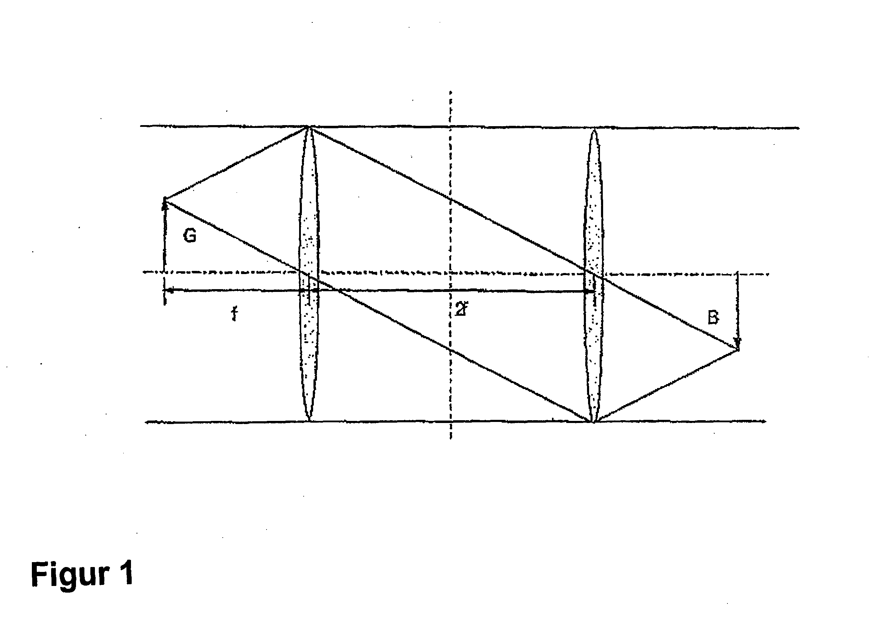

In Figur 1 ist eine schematische Darstellung einer Transferlinseneinrichtung gezeigt, wie sie im Stand der Technik bekannt ist. Die Transferlinseneinrichtung besteht aus einem Duplet in f-2f-f-

Anordnung. Mit dieser Anordnung kann die Austrittsebene bzw. der Austrittsspalt der Größe G als negatives Bild der Größe B abgebildet werden. Eine solche Transferlinse wird beispielsweise zwischen zwei Halbkugelanalysatoren verwendet, wie in der EP 1 559 126 beschrieben. Das Transferlinsensystem hat Bildfehler, insbesondere sphärische und chromatische Aberration. Gemäß dem Scherzer-Theorem lassen sich diese Bildfehler hier grundsätzlich nicht vollständig vermeiden.

Die Bildfehler wirken sich auf die Abbildungsqualität und die erreichbare Transmission eines Spektroskops aus. Darüber hinaus tragen die Bildfehler solcher Transferlinsen stärker zum Endbild bei als dies bei anderen Linsensystemen der Fall ist, da die Transferlinseneinrichtung nicht vergrößert. Da die Größe der Bildfehler umso größer werden, je größer der verwendete Raumwinkel ist, muss bei den bekannten Spektroskopen der Akzeptanzwinkel und damit die transmittierte Intensität begrenzt werden.

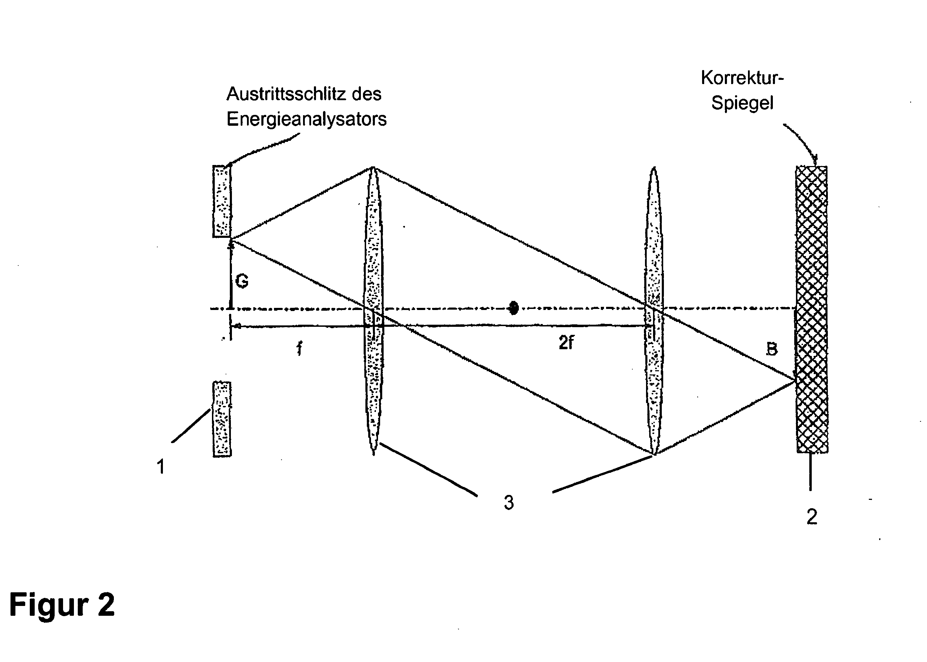

Erfindungsgemäß wird daher ein Spiegelelement verwendet, das die geladenen Teilchen, z. B. die Elektronen, reflektiert und durch den toroidalen Energieanalysator zurückschickt. Eine Ausführungsform der erfindungsgemäßen Anordnung ist in Figur 2 gezeigt. Dabei ist in einer bevorzugten Ausführungsform vorgesehen, dass das Spiegelelement 2 leicht gekrümmt ist, um die Aberrationen des Linsendupletts der Transferlinseneinrichtung 3 zu korrigieren.

Grundsätzlich wäre es möglich, den Reflexionsspiegel 2 auch direkt an den Austritt des Energieanalysators zu positionieren. Allerdings haben die meisten Reflexionselemente für geladene Teilchen selbst eine feste, negative sphärische und chromatische Aberration. Gewünscht wird an dieser Stelle aber ein idealer Spiegel ohne Aberration. Zweckmäßig kann auch ein Spiegel mit einstellbarer negativer Aberration sein, da damit eventuell an anderer Stelle vorhandene Aberrationen reduziert werden können.

Daher wird zweckmäßigerweise die in Figur 2 gezeigte Anordnung verwendet.

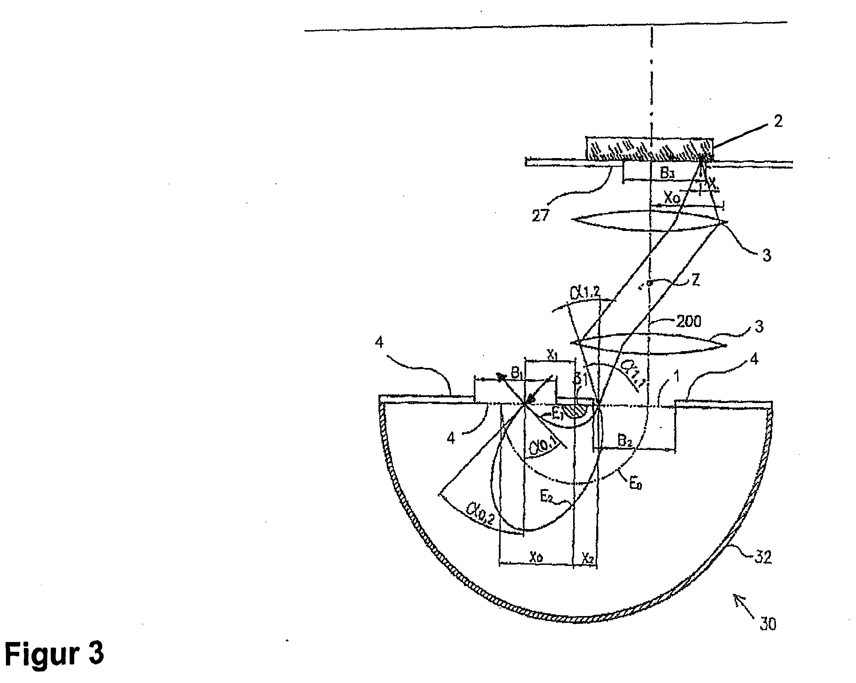

In Figur 3 ist ein Halbkugelanalysator 30 mit Transferlinse 3 und Reflexionsspiegel 2 dargestellt. Der Halbkugelanalysator 30 hat eine Eintrittsfläche 4 und eine Austrittsfläche 1. Elektronen, die in die Eintrittsfläche 4 des Analysators eintreten, werden aufgrund der Potentialdifferenz zwischen einer inneren Halbkugel 31 und einer äußeren Halbkugel 32 abgelenkt. Durch Einstellen der Potentialdifferenz kann festgelegt werden, welche Energie diejenigen Elektronen haben, die die Austrittsfläche 1 des Energieanalysators erreichen. Aufgrund der fokussierenden Eigenschaft des Halbkugelanalysators werden alle Elektronen mit gleicher Energie, die mit unterschiedlichen Einfallswinkeln auf die Eintrittsfläche 4 des Halbkugelanalysators treffen, auf dem gleichen Punkt der Austrittsfläche 1 gelenkt. Mit Hilfe des Halbkugelanalysators können daher Elektronen mit einer bestimmten Energie gezählt werden. Durch Verändern der Potentialdifferenz können jedem Energiewert eine bestimmte Anzahl von Elektronen zugeordnet werden.

Allerdings geht dabei die Orts- und Winkelinformation, d. h. die Information über den Eintrittswinkel in die Eintrittsfläche des Halbkugelanalysators und die Ortsinformation verloren, aus der jedoch Rückschlüsse auf die Herkunftsposition der geladenen Teilchen gezogen werden könnten. Daher werden die aus der Austrittsebene 1 des Energieanalysators austretenden Elektronen mit Hilfe der Transferlinseneinrichtung 3 auf dem Spiegelelement 2 abgebildet und dort reflektiert, so dass die reflektierten Elektronen durch die Transferlinseneinrichtung 3 auf der Austrittsebene 1 des Energieanalysators abgebildet werden. Die Elektronen durchlaufen dann den Energieanalysator in umgekehrter Richtung, so dass sie in Pfeilrichtung aus der Eintrittsebene 4 aus dem Energieanalysator austreten. Der Energieanalysator wird somit zweimal durchlaufen. Die austretenden Elektronen werden dann durch ein Magnetfeld, wie im Folgenden noch beschrieben wird, von den einfliegenden getrennt.

Durch die Verwendung des als Korrekturspiegel dienenden Spiegelelement 2 können die Bildfehler der Transferlinseneinrichtung 3 deutlich reduziert werden.

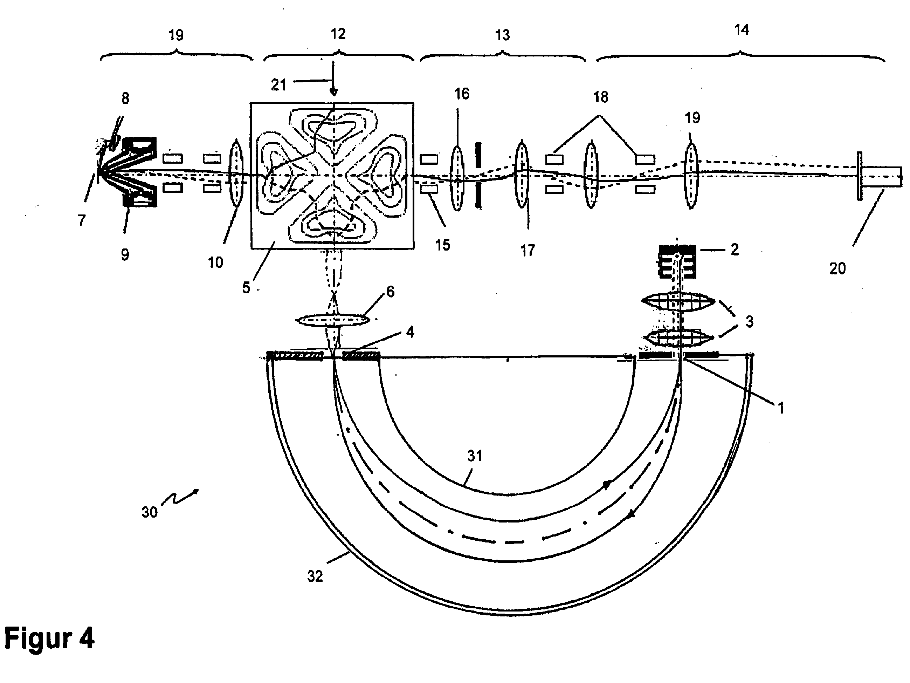

In Figur 4 ist ein erfindungsgemäßes Spektroskop dargestellt. Eine zu untersuchende Probe 7 ist in einem Probenhalter angeordnet. Die Probe kann mit Röntgenstrahlung 8 bestrahlt werden. Alternativ oder in Kombination dazu können auch Elektronen 21 aus einen Elektronenkanone auf die Probe aufgebracht werden. Um die Elektronen 21 aus der Elektronenkanone auf die Probe aufzubringen, ist ein Magnetumlenker 5 vorgesehen, der die Elektronen 21 derart umlenkt, so dass sie mit Hilfe der Feldlinse 10 und der Immersionslinse 9 auf die Probe abgebildet werden. Die Röntgenstrahlen 8 und/oder die Elektronen 21 werden mit der Oberfläche der zu untersuchenden Probe 7 wechselwirken und - je nach eingestelltem Potential - dort reflektiert werden oder Elektronen herauslösen.

Die Energie der Elektronen sowie deren Abstrahlrichtung oder Ortsverteilung erlaubt den Rückschluss auf Eigenschaften der Probe. Daher werden die herausgelösten Elektronen mit Hilfe der Immersionstinse 9 und der Feldlinse 10 in den Magnetfeldumlenker 5 abgebildet. Der Magnetfeldumlenker 5 lenkt die Elektronen derart ab, dass sie mit Hilfe der Linse 6 auf die Eintrittsebene 4 des Energieanalysators 30, der hier ein Halbkugelanalysator bestehend aus einer inneren Halbkugel 31 und einer äußeren Halbkugel 32 ist, abgebildet.

Durch die Wahl der Potentialdifferenz zwischen der inneren Halbkugel 31 und der äußeren Halbkugel 32 sowie der Breite des Austrittsschlitzes 1 des Energieanalysators wird bestimmt, welche Energien diejenigen Elektronen haben, die aus dem Austrittsschlitz 1 austreten. Diese Elektronen werden über die Transferlinseneinrichtung 3 auf das Spiegelelement 2 abgebildet; welches die Elektronen reflektiert, so dass sie über die Transferlinseneinrichtung 3 auf den Austrittsschlitz 1 rückabgebildet werden. Die reflektierten Elektronen durchlaufen dann den Halbkugelanalysator 30 erneut und treten über die Eintrittsfläche 4 aus dem Energieanalysator aus. Sie werden dann erneut von der Linse 6 in den Magnetfeldumlenker fokussiert, der die austretenden Elektronen in eine Transferoptik 13 bestehend aus einem Detektor 15, Transferlinsen 16 sowie Zwischenlinsen 17 besteht.

Die Elektronen werden dann über den Deflektor 18 und die Projektorlinse 19 auf einen Detektor 20, der hier ein CCD-Detektor ist, abgebildet.

Das Spektroskop besteht somit aus den Objektivlinsen 19, dem Magnetfeldumlenker 12, der Transferoptik 13, der Projektions-/Detektionsvorrichtung 14 sowie dem Energieanalysator 30.

In Figur 4 liegt die dispersive Ebene des Energieanalysators 30 in der Papierebene, in der auch eine gedachte Linie zwischen der Probe 7 und dem Detektor 20 liegt. Zweckmäßig ist es jedoch, wenn die dispersive Ebene senkrecht zur Papierebene steht, da dann aufgrund der räumlichen Trennung von Projektions-/Detektionsvorrichtung 14 und Spiegelelement 2 eine größere Freiheit bei der Dimensionierung und Positionierung der einzelnen Komponenten besteht.

### Bezugszeichenliste

- 1: Austrittsschlitz
- 2: Spiegelelement
- 3: Transferlinseneinrichtung
- 4: Eintrittsfläche
- 5: Magnetfeldumlenker
- 6: Linse
- 7: Probe
- 8: Röntgenstrahlung
- 9: Immersionslinse
- 10: Feldlinse
- 12: Magnetfeldumlenker
- 13: Transferoptik
- 14: Projektions-/Detektionsvorrichtung
- 15: Detektor
- 16: Transferlinsen
- 17: Zwischenlinsen
- 18: Deflektor
- 19: Projektorlinse
- 20: Detektor
- 21: Elektronen
- 30: Energieanalysator
- 31: innere Halbkugel
- 32: äußere Halbkugel

## Patentansprüche

1. Bildgebender Energiefilter für elektrisch geladene Teilchen mit einem toroidalen Energieanalysator (30), vorzugsweise mit einem Halbkugelanalysator, mit einer Eintrittsebene und einer Austrittsebene, **gekennzeichnet durch** ein Spiegelelement (2) für elektrisch geladene Teilchen, das derart angeordnet ist, dass geladene Teilchen, welche den toroidalen Energieanalysator (30) über die Austrittsebene verlassen, **durch** das Spiegelelement (2) zurück in den toroidalen Energieanalysator (30) reflektiert werden, so dass die geladenen Teilchen den toroidalen Energieanalysator (30) ein weiteres mal in umgekehrter Laufrichtung durchlaufen.

2. Energiefilter nach Anspruch 1, weiter **dadurch gekennzeichnet, dass** zwischen Austrittsebene und Spiegelelement eine Transferlinseneinrichtung (3) angeordnet ist, wobei die Transferlinseneinrichtung (3) vorzugsweise eine Linearvergrößerung V_{L} = ZB₂/ZB₁< 0 und besonders bevorzugt zwischen - 0,9 und -1,1, und am besten von -1 aufweist.

3. Energiefilter nach Anspruch 2, weiter **dadurch gekennzeichnet, dass** die Transferlinseneinrichtung (3) mindestens zwei Linsenelemente für elektrisch geladenen Teilchen aufweist.

4. Energiefilter nach einem der Ansprüche 1 bis 3, weiter **dadurch gekennzeichnet, dass** das Spiegelelement (2) ein elektrostatischer Spiegel ist.

5. Energiefilter nach einem der Ansprüche 1 bis 4, mit einem Magnetumlenker (12) mit einer Eintrittsfläche (4) für geladene Teilchen, einer Energiefilterfläche und einer Austrittsfläche für energiegefilterte geladene Teilchen, der derart angeordnet ist,
dass geladene Teilchen, die unter einem Eintrittswinkel α, der vorzugsweise kleiner als 20° ist, auf die Eintrittsfläche (4) des Magnetumlenkers (12) treffen, durch den Magnetumlenker (12) umgelenkt werden, so dass sie unter einem Austrittswinkel β, der vorzugsweise kleiner als 20° ist, aus der Energiefilterfläche des Magnetumlenkers (12) austreten, und unter einem Eintrittswinkel γ, der vorzugsweise kleiner als 20° ist, auf die Eintrittsfläche des toroidalen Energieanalysator (30) treffen und
dass geladene Teilchen, die unter einem Austrittswinkel δ aus der Eintrittsfläche des toroidalen Analysators (30) austreten, unter einem Eintrittswinkel ε, der vorzugsweise kleiner als 20° ist, auf die Energiefilterfläche des Magnetumlenkers (12) treffen, von dem Magnetumlenker (12) umgelenkt werden, so dass sie unter einem Austrittswinkel ζ, der vorzugsweise kleiner als 20° ist, die Austrittsfläche des Magnetumlenkers (12) verlassen, wobei vorzugsweise zwischen Magnetumlenker (12) und toroidalem Analysator (30) eine Immersionslinse (9) vorgesehen ist.

6. Spektroskop für geladene Teilchen mit einem Energiefilter nach einem der Ansprüche 1 bis 5, wobei das Spektroskop vorzugsweise ein Elektronenspektroskop ist.

7. Spektroskop nach Anspruch 6, mit einem Detektor (15) zur Erfassung der über die Eintrittsfläche des toroidalen Analysators (30) austretenden geladenen Teilchen, wobei der Detektor (15) vorzugsweise ein CCD-Detektor und besonders bevorzugt ein Kanalplattenvervielfacher mit Leuchtschirm und nachgeordneten CCD-Detektor, ist.

8. Spektroskop nach Anspruch 7 mit einem Energiefilter nach Anspruch 6, wobei vorgesehen ist und der Detektor (15) die über die Austrittsfläche des Magnetumlenkers (12) austretenden geladenen Teilchen erfasst.

9. Spektroskop nach einem der Ansprüche 6 bis 8, mit einer Probenaufnahme, die derart angeordnet ist, dass von einer auf der Probenaufnahme angeordneten Probe (7) emittierte geladene Teilchen gegebenenfalls nach Durchlaufen einer Abbildungsoptik unter einem Eintrittswinkel γ, der vorzugsweise kleiner als 20° ist, auf die Eintrittsfläche des toroidalen Energieanalysator (30) treffen oder, falls ein Energiefilter nach Anspruch 6 verwendet wird, unter einem Eintrittswinkel α, der vorzugsweise kleiner als 20° ist, auf die Eintrittsfläche des Magnetumlenkers (12) treffen.

10. Spektroskop nach Anspruch 9, mit einer Strahlungsquelle, vorzugsweise einer Elektronenkanone, zur Beaufschlagung einer auf der Probenaufnahme aufgenommenen Probe (7) mit Strahlung.

11. Spektroskop nach Anspruch 10 mit einem Energiefilter nach Anspruch 5, weiter **dadurch gekennzeichnet, dass** der Magnetumlenker (12) eine Strahlungseintrittsfläche hat und die Strahlungsquelle derart angeordnet ist, dass Strahlung unter einem Eintrittswinkel η, der vorzugsweise kleiner als 10° ist, auf die Strahlungseintrittsfläche trifft und von dem Magnetumlenker (12) derart umgelenkt wird, dass sie unter einem Austrittswinkel θ, der vorzugsweise kleiner als 10° ist, aus der Eintrittsfläche des Magnetumlenkers (12) austritt und auf die Probenaufnahme gerichtet wird.

12. Spektroskop nach einem der Ansprüche 9 bis 11, weiter **dadurch gekennzeichnet, dass** die dispersive Ebene des toroidalen Analysators (30) im wesentlichen senkrecht zu einer zwischen Probenaufnahme und Detektor (15) verlaufenden gedachten Linie angeordnet ist.

13. Spektroskop nach einem der Ansprüche 6 bis 12, weiter **dadurch gekennzeichnet, dass** es ein abbildendes ESCA-Elektronenspektroskop ist.

## Claims

1. An imaging energy filter for electrically charged particles with a toroidal energy analyzer (30), preferably with a hemispherical analyzer, with an entrance plane and an exit plane, **characterized by** a mirror element (2) for electrically charged particles being so arranged that charged particles which leave the toroidal energy analyzer (30) by way of the exit plane are reflected back into the toroidal energy analyzer (30) by the mirror element (2) so that the charged particles pass through the toroidal energy analyzer (30) a further time in the opposite travel direction.

2. An energy filter as set forth in claim 1 further **characterized in that** a transfer lens device (3) is arranged between the exit plane and the mirror element, wherein the transfer lens device (3) preferably has a linear magnification V_{L} = ZB₂/ZB₁< 0 and particularly preferably between -0.9 and -1.1 and best of -1.

3. An energy filter as set forth in claim 2 further **characterized in that** the transfer lens device (3) has at least two lens elements for electrically charged particles.

4. An energy filter as set forth in one of claims 1 through 3 further **characterized in that** the mirror element (2) is an electrostatic mirror.

5. An energy filter as set forth in one of claims 1 through 4 with a magnetic diverter (12) having an entrance surface (4) for charged particles, an energy filter surface and an exit surface for energy-filtered charged particles which is so arranged
that charged particles which are incident on the entrance surface (4) of the magnetic diverter (12) at an angle of incidence α which is preferably less than 20° are diverted by the magnetic diverter (12) so that they issue from the energy filter surface of the magnetic diverter (12) at an exit angle β which is preferably less than 20° and are incident on the entrance surface of the toroidal energy analyzer (30) at an entrance angle γ which is preferably less than 20°, and
that charged particles which issue from the entrance surface of the toroidal analyzer (30) at an exit angle δ are incident on the energy filter surface of the magnetic diverter (12) at an entrance angle ε which is preferably less than 20° and are diverted by the magnetic diverter (12) so that they leave the exit surface of the magnetic diverter (12) at an exit angle ζ which is preferably less than 20°, wherein preferably an immersion lens (9) is provided between the magnetic diverter (12) and the toroidal analyzer (30).

6. A spectroscope for charged particles comprising an energy filter as set forth in one of claims 1 through 5 wherein the spectroscope is preferably an electron spectroscope.

7. A spectroscope as set forth in claim 6 with a detector (15) for detecting the charged particles issuing by way of the entrance surface of the toroidal analyzer (30), wherein the detector (15) is preferably a CCD detector and particularly preferably a channel plate multiplier with fluorescent screen and downstream-disposed CCD detector.

8. A spectroscope as set forth in claim 7 with an energy filter as set forth in claim 6, wherein the detector (15) detects the charged particles issuing by way of the exit surface of the magnetic diverter (12).

9. A spectroscope as set forth in one of claims 6 through 8 with a sample receiving means so arranged that charged particles emitted by a sample (7) arranged on the sample receiving means, possibly after passing through an optical imaging system at an angle of incidence γ which is preferably less than 20° are incident on the entrance surface of the toroidal energy analyzer (30) or, if an energy filter as set forth in claim 6 is used, they are incident on the entrance surface of the magnetic diverter (12) at an angle of incidence α which is preferably less than 20°.

10. A spectroscope as set forth in claim 9 with a radiation source, preferably an electron gun, for acting with radiation on a sample (7) received on the sample receiving means.

11. A spectroscope as set forth in claim 10 having an energy filter as set forth in claim 5 further **characterized in that** the magnetic diverter (12) has a radiation entrance surface and the radiation source is so arranged that radiation is incident on the radiation entrance surface at an entrance angle η which is preferably less than 10° and is diverted by the magnetic diverter (12) in such a way that it issues from the entrance surface of the magnetic diverter (12) at an exit angle θ which is preferably less than 10° and is directed on to the sample receiving means.

12. A spectroscope as set forth in one of claims 9 through 11 further **characterized in that** the dispersive plane of the toroidal analyzer (30) is arranged substantially perpendicularly to a notional line extending between the sample receiving means and the detector (15).

13. A spectroscope as set forth in one of claims 6 through 12 further **characterized in that** it is an imaging ESCA electron spectroscope.

## Revendications

1. Filtre d'énergie pour imagerie pour particules chargées électriquement, avec un analyseur d'énergie toroïdal (30), de préférence avec un analyseur hémisphérique, avec un plan d'entrée et un plan de sortie, **caractérisé par** un élément réfléchissant (2) pour des particules chargées électriquement qui est disposé de telle sorte que des particules chargées qui quittent l'analyseur d'énergie toroïdal (30) via le plan de sortie sont réfléchies par l'élément réfléchissant (2) vers l'analyseur d'énergie toroïdal (30) de telle sorte que les particules chargées parcourent l'analyseur d'énergie toroïdal (30) une nouvelle fois dans le sens opposé.

2. Filtre d'énergie selon la revendication 1, également **caractérisé en ce qu'**un dispositif de lentille de transfert (3) est disposé entre le plan de sortie et l'élément réfléchissant, le dispositif de lentille de transfert (3) présentant de préférence un grossissement linéaire V_{L} = ZB₂/ZB₁<0 et, de façon particulièrement préférée, entre -0,9 et -1,1, et au mieux de -1.

3. Filtre d'énergie selon la revendication 2, également **caractérisé en ce que** le dispositif de lentille de transfert (3) présente au moins deux éléments de lentille pour des particules chargées électriquement.

4. Filtre d'énergie selon une des revendications 1 à 3, également **caractérisé en ce que** l'élément réfléchissant (2) est un miroir électrostatique.

5. Filtre d'énergie selon une des revendications 1 à 4, avec un déflecteur magnétique (12) avec une surface d'entrée (4) pour des particules chargées, avec une surface de filtre d'énergie et avec une surface de sortie pour les particules chargées filtrées en énergie, qui est disposé de telle sorte
que des particules chargées qui heurtent la surface d'entrée (4) du déflecteur magnétique (12) selon un angle d'entrée α qui est de préférence inférieur à 20° sont déviées par le déflecteur magnétique (12) de telle sorte qu'elles quittent la surface de filtre d'énergie du déflecteur magnétique (12) selon un angle de sortie β qui est de préférence inférieur à 20°, et heurtent la surface d'entrée de l'analyseur d'énergie toroïdal (30) selon un angle d'entrée γ qui est de préférence inférieur à 20°, et
que des particules chargées qui quittent la surface d'entrée de l'analyseur d'énergie toroïdal (30) selon un angle de sortie δ heurtent la surface de filtre d'énergie du déflecteur magnétique (12) selon un angle d'entrée ε qui est de préférence inférieur à 20°, sont déviées par le déflecteur magnétique (12) de telle sorte qu'elles quittent la surface de sortie du déflecteur magnétique (12) selon un angle de sortie ζ qui est de préférence inférieur à 20°, une lentille à immersion (9) étant de préférence prévue entre le déflecteur magnétique (12) et l'analyseur d'énergie toroïdal (30).

6. Spectroscope pour particules chargées avec un filtre d'énergie selon une des revendications 1 à 5, le spectroscope étant de préférence un spectroscope électronique.

7. Spectroscope selon la revendication 6, avec un détecteur (15) pour la détection des particules chargées sortant via la surface d'entrée de l'analyseur d'énergie toroïdal (30), le détecteur (15) étant de préférence un détecteur CCD et de façon particulièrement préférée un multiplicateur du type à plaque à canaux avec écran luminescent et détecteur CCD disposé en aval.

8. Spectroscope selon la revendication 7, avec un filtre d'énergie selon la revendication 6, le détecteur (15) détectant les particules chargées sortant via la surface de sortie du déflecteur magnétique (12).

9. Spectroscope selon une des revendications 6 à 8, avec un compartiment d'échantillons qui est disposé de telle sorte que, éventuellement après avoir parcouru une optique de reproduction, des particules chargées émises par un échantillon (7) disposé sur le compartiment d'échantillons heurtent, selon un angle d'entrée γ qui est de préférence inférieur à 20°, la surface d'entrée de l'analyseur d'énergie toroïdal (30) ou, en cas d'utilisation d'un filtre d'énergie selon la revendication 6, heurtent la surface d'entrée du déflecteur magnétique (12) selon un angle d'entrée α qui est de préférence inférieur à 20°.

10. Spectroscope selon la revendication 9, avec une source de rayonnement, de préférence un canon à électrons, pour alimenter en rayonnement un échantillon (7) logé sur le compartiment d'échantillons.

11. Spectroscope selon la revendication 10, avec un filtre d'énergie selon la revendication 5, caractérisé également en ce que le déflecteur magnétique (12) a une surface d'entrée de rayonnement, et en ce que la source de rayonnement est disposée de telle sorte que le rayonnement heurte la surface d'entrée de rayonnement selon un angle d'entrée η qui est de préférence inférieur à 10°, et est dévié par le déflecteur magnétique (12) de telle sorte qu'il sort de la surface d'entrée du déflecteur magnétique (12) selon un angle de sortie θ qui est de préférence inférieur à 10°, et est dirigé vers le compartiment d'échantillons.

12. Spectroscope selon une des revendications 9 à 11, caractérisé également en ce que le plan dispersif de l'analyseur d'énergie toroïdal (30) est disposé de façon essentiellement perpendiculaire à une ligne imaginaire s'étendant entre le compartiment d'échantillons et le détecteur (15).

13. Spectroscope selon une des revendications 6 à 12, caractérisé également en ce qu'il s'agit d'un spectroscope électronique ESCA de reproduction.
